# EUROPÄISCHE PATENTSCHRIFT

(11) **EP 0 676 054 B1**
(45) Veröffentlichungstag und Bekanntmachung des Hinweises auf die Patenterteilung: **02.10.1996**
(21) Anmeldenummer: 94901745.3
(22) Anmeldetag: 10.12.1993
(51) Int. Cl.: G01R 21/00

(54) **VERFAHREN UND EINRICHTUNG ZUM BESTIMMEN DER WIRKLEISTUNG EINES ELEKTRISCHEN ANTRIEBS**
PROCESS AND DEVICE FOR FINDING THE REAL OUTPUT OF AN ELECTRIC DRIVE
PROCEDE ET INSTALLATION POUR LA DETERMINATION DE LA PUISSANCE UTILE D'UN ENTRAINEMENT ELECTRIQUE

(30) Priorität: 23.12.1992 DE 4243914
(43) Veröffentlichungstag der Anmeldung: 11.10.1995
(73) Patentinhaber: SIEMENS AKTIENGESELLSCHAFT, 80333 München (DE)
(72) Erfinder: KUTZER, Heinz, D-63477 Maintal (DE)
(86) Internationale Anmeldenummer: DE9301183
(87) Internationale Veröffentlichungsnummer: WO9415221

(56) Entgegenhaltungen:
- DD-A- 272 710

## Beschreibung

Die Erfindung betrifft ein Verfahren zum Bestimmen der Wirkleistung eines elektrischen Antriebes, insbesondere eines elektrischen Armaturenantriebes, wobei von der gemessenen Wirkleistung der ohmsche Leistungsverlust, der im Ständer des Antriebs gegeben ist, subtrahiert wird. Die Erfindung betrifft auch eine Einrichtung zum Bestimmen der Wirkleistung eines elektrischen Antriebs, insbesondere eines elektrischen Armaturenantriebs, der Anschlußleitungen für Ständerwicklungen des Antriebs umfaßt.

Eine Armaturendiagnose ist ein an einer Armatur durchzuführendes Meß- und Auswerteverfahren. Mit diesem Verfahren kann frühzeitig erkannt werden, ob sich der Zustand der Armatur so geändert hat, daß ein Versagen oder zumindest eine eingeschränkte Funktionsweise der Armatur zu befürchten ist. Zur Armaturendiagnose gehört das Messen der Wirkleistung eines elektrischen Antriebs der Armatur. Eine Änderung der Wirkleistung, insbesondere in Verbindung mit einer Änderung anderer Größen, läßt auf eine Störung an der Armatur schließen.

Es ist bereits bekannt, daß die gemessene Wirkleistung korrigiert werden muß, bevor sie einen Hinweis auf den Zustand der Armatur geben kann.

Es ist bereits vorgeschlagen worden, daß zur Korrektur der Wirkleistung der ohmsche Verlust im Ständer des Armaturenantriebs, sowie der induktive Verlust im Ständer und die ohmschen und induktiven Verluste im Rotor des Antriebs von der gemessenen Wirkleistung subtrahiert werden.

Die dadurch gewonnenen korrigierten Wirkleistungswerte sind Schwankungen unterworfen, die nicht auf Defekte an der Armatur zurückgeführt werden können. Eine zuverlässige Armaturendiagnose ist also mit diesen korrigierten Werten für die Wirkleistung eines elektrischen Antriebs nicht möglich.

Der Erfindung liegt die Aufgabe zugrunde, ein Verfahren zum Bestimmen der Wirkleistung eines elektrischen Antriebs anzugeben, das einen Wirkleistungswert ermitteln läßt, der eindeutig eine Störung des Antriebs oder der Armatur, zu der der Antrieb gehört, anzeigt. Es soll auch eine geeignete Einrichtung zum Bestimmen der Wirkleistung eines elektrischen Antriebs angegeben werden.

Davon ausgehend, daß von der gemessenen Wirkleistung der ohmsche Leistungsverlust, der im Ständer des Antriebs gegeben ist, subtrahiert wird, wird die erste Aufgabe gemäß der Erfindung dadurch gelöst, daß auch der ohmsche Leistungsverlust, der in der Anschlußleitung des Antriebs gegeben ist, subtrahiert wird.

Der Erfindung liegt nämlich die Erkenntnis zugrunde, daß die Änderung des Leistungsverlusts in der Anschlußleitung des Antriebs relativ groß ist, während die Änderungen der induktiven Verluste im Ständer und die Änderungen der Verluste im Rotor vernachlässigbar klein sind. Diese Verluste wurden bisher berücksichtigt. Ein weitgehend konstanter Verlust stört nicht, da er z.B. das Erkennen einer Störung nicht beeinträchtigt.

Mit dem Verfahren nach der Erfindung wird der Vorteil erzielt, daß eine korrigierte Wirkleistung bestimmt werden kann, die der vom Antrieb abgegebenen mechanischen Leistung sehr nahekommt. Erst dadurch, daß der bisher nichtberücksichtigte ohmsche Verlust in der Anschlußleitung des Antriebs berücksichtigt wird, ist die korrigierte Wirkleistung mit der abgegebenen mechanischen Leistung weitgehend identisch. Da die abgegebene mechanische Leistung einen Hinweis auf die Zuverlässigkeit des Antriebs und der angetriebenen Armatur gibt, ist mit dem Verfahren nach der Erfindung eine gute, zuverlässige Diagnose, z.B. Armaturendiagnose, durchzuführen.

Leistungsverluste im Rotor des Antriebs werden beispielsweise nicht berücksichtigt. Es hat sich herausgestellt, daß diese Verluste im Vergleich zum Leistungsverlust in der Anschlußleitung sehr klein sind. Man kann also auch ohne das Bestimmen der Verluste im Rotor eine zuverlässige Aussage über die korrigierte Wirkleistung und damit über den Zustand des Antriebs und der Armatur bekommen.

Beispielsweise werden keine induktiven Leistungsverluste beim Bestimmen der Wirkleistung berücksichtigt. Es hat sich nämlich auch herausgestellt, daß die induktiven Verluste im Vergleich zum Leistungsverlust in der Anschlußleitung vernachlässigbar klein sind. Damit wird der Vorteil erzielt, daß man eine zuverlässige Aussage über den Zustand des Antriebs und der Armatur auch ohne aufwendiges Bestimmen der induktiven Leistungsverluste bekommt.

Mit dem Verfahren nach der Erfindung wird über die korrigierte Wirkleistung die vom Antrieb abgegebene mechanische Leistung so zuverlässig bestimmt, daß mit der korrigierten Wirkleistung, gegebenenfalls zusammen mit anderen elektrischen Meßgrößen, bei einer Diagnose der Zustand des Antriebs und der Armatur gut bestimmt werden kann. Es müssen zusätzlich keine mechanischen Größen bei einer Armaturendiagnose gemessen werden, was wegen aufwendiger Meßverfahren Fehlerquellen beinhalten würde. Der mit dem Verfahren nach der Erfindung bestimmte korrigierte Wert für die Wirkleistung entspricht der vom Antrieb abgegebenen mechanischen Leistung soweit, daß eine zuverlässige Armaturendiagnose auch ohne Messen mechanischer Größen durchführbar ist.

Die zweite Aufgabe, eine Einrichtung zum Bestimmen der Wirkleistung eines elektrischen Antriebs, der Anschlußleitungen für Ständerwicklungen des Antriebs umfaßt, anzugeben, wird gemäß der Erfindung dadurch gelöst, daß jeweils zwei der Anschlußleitungen an antriebsfernen Anschlußpunkten durch Leitungspaare mit einer Gleichspannungsquelle verbunden sind, daß jeweils in eine der Leitungen der Leitungspaare ein bekannter ohmscher Widerstand eingefügt ist, daß diese Leitung zwischen dem ohmschen Widerstand und dem Anschlußpunkt über einen Spannungsmesser mit der anderen Leitung des jeweiligen Leitungspaares verbunden ist und daß die Spannungsmesser mit einer Auswerteeinheit verbunden sind.

Dort werden die ohmschen Leistungsverluste in der Anschlußleitung und im Ständer berechnet und von einer gemessenen Wirkleistung subtrahiert.

Die Spannungsmesser sind beispielsweise Bestandteil der Auswerteeinheit. Diese ist dann zur Spannungsmessung mit Spannungsabgriffen an den Leitungspaaren verbunden.

Die Gleichspannungsquellen werden nur beim Messen der Leistungsverluste benötigt. Im Betriebszustand des Antriebs liegt an dessen Anschlußleitungen eine Wechselspannung an. Zum Bestimmen der Leistungsverluste wird an Anschlußpunkten mit den Anschlußleitungen eine Korrekturvorrichtung verbunden. Bei ausgeschalteter Wechselspannung wird dann durch die Gleichspannungsquellen, die sich in der Korrekturvorrichtung befinden, dem Antrieb Gleichstrom zugeleitet. Die Anschlußpunkte befinden sich nicht unmittelbar am Antrieb, sondern im Bereich der antriebsfernen Enden der Anschlußleitungen. Dadurch ist sichergestellt, daß neben dem ohmschen Leistungsverlust im Ständer des Antriebs, der mit den Anschlußleitungen verbunden ist, auch der ohmsche Leistungsverlust in den gesamten Anschlußleitungen gemessen werden kann.

Bei der Einrichtung nach der Erfindung sind über die Anschlußpunkte jeweils zwei der Anschlußleitungen durch Leitungspaare mit einer Gleichspannungsquelle zu verbinden. In jeweils eine der beiden Leitungen eines Leitungspaares ist ein bekannter ohmscher Widerstand eingefügt. Diese Leitung ist antriebsseitig vom ohmschen Widerstand, zwischen dem ohmschen Widerstand und dem Anschlußpunkt über einen Spannungsmesser mit der anderen Leitung des Leitungspaares verbunden. Die Spannungsmesser sind mit einer Auswerteeinheit verbunden. Sie können auch Bestandteil dieser Auswerteeinheit sein. Dort werden die ohmschen Verluste in der Anschlußleitung und im Ständer berechnet. Dazu wird nur noch der Wert der Stromstärke in der Anschlußleitung benötigt. Zur Korrektur einer zuvor gemessenen Gesamtwirkleistung wird von dieser der berechnete ohmsche Leistungsverlust subtrahiert. Der verbleibende korrigierte Wert entspricht weitgehend der vom Antrieb abgegebenen mechanischen Leistung. Er kann daher auch ohne zusätzliche mechanische Größen bei einer Diagnose einer mit dem Antrieb verbundenen Armatur deren Zuverlässigkeit anzeigen.

Mit dem Verfahren und der Einrichtung nach der Erfindung ist, insbesondere allein mit elektrischen Meßgrößen, eine zuverlässige Armaturendiagnose gewährleistet.

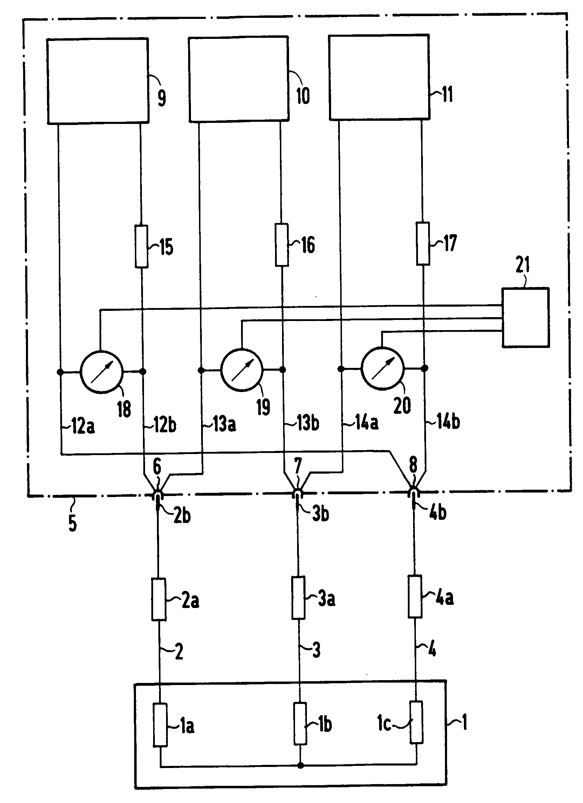

Das Verfahren und die Einrichtung nach der Erfindung werden anhand der Zeichnung näher erläutert:

Die Zeichnung zeigt ein Ersatzschaubild für einen Antrieb mit Anschlußleitung verbunden mit einer Einrichtung zum Bestimmen der Wirkleistung des Antriebs.

Ein elektrischer Antrieb 1, der beispielsweise ein Armaturenantrieb ist, weist einen Ständer und einen Rotor auf. Zur Energieversorgung sind Anschlußleitungen 2, 3, 4 mit dem Ständer des Antriebes 1 verbunden. Zum Bestimmen der Wirkleistung des elektrischen Antriebes 1 wird das Produkt aus der anliegenden Spannung und der Stromstärke des fließenden Stromes bestimmt. Die Wirkleistung soll einen Hinweis auf den mechanischen Zustand des Antriebes 1, insbesondere der mit dem Antrieb 1 verbundenen Armatur, geben. Dazu ist es notwendig, daß Leistungsverluste bestimmt und die gemessene Wirkleistung korrigiert wird. Wesentlich für das Verfahren und die Einrichtung nach der Erfindung ist die Feststellung, daß die Leistungsverluste im Rotor und die induktiven Verluste im Ständer so gering sind, daß sie nicht berücksichtigt werden müssen. Andererseits dürfen die ohmschen Leistungsverluste in den Anschlußleitungen des Antriebs nicht unberücksichtigt bleiben.

Die Zeichnung zeigt den Antrieb 1, dem drei Anschlußleitungen 2, 3, 4 zugeordnet sind. Als Ersatzschaubild ist der ohmsche Widerstand der Ständerwicklung des Antriebs 1 durch die Widerstände 1a, 1b, 1c dargestellt. Die ohmschen Widerstände der langen Anschlußleitungen 2, 3, 4, die sich von einer Kraftwerkswarte bis zu einer Armatur im Kraftwerk über eine Distanz von mehr als 100 m erstrecken können, sind in der Zeichnung als Ersatzschaubild durch die ohmschen Widerstände 2a, 3a, 4a dargestellt.

Zum Bestimmen der ohmschen Leistungsverluste im Ständer des Antriebs 1 und in den Anschlußleitungen 2, 3, 4 ist eine Korrekturvorrichtung 5 vorgesehen, die nach Ausschalten der Spannungsversorgung des Antriebs 1 an Anschlußpunkten 2b, 3b, 4b der Anschlußleitungen 2, 3, 4 angeschlossen werden kann. Die Anschlußpunkte 2b, 3b, 4b, die Anschlußbuchsen sein können, befinden sich in der Nähe der antriebsfernen Enden der Anschlußleitungen 2, 3, 4.

Die Korrekturvorrichtung 5 weist Stecker 6, 7, 8 auf, die mit den Anschlußbuchsen der Anschlußpunkte 2b, 3b, 4b zu verbinden sind. Statt der Stecker 6, 7, 8 können auch andere Anschlußelemente vorhanden sein. Jeweils zwei Stecker 6, 7, 8 sind mit einer Gleichspannungsquelle 9, 10, 11 verbunden. Damit der Leistungsverlust schnell und zuverlässig bestimmt werden kann, sind für drei Anschlußleitungen 2, 3, 4 drei Gleichspannungsquellen 9, 10, 11 vorgesehen. Man könnte auch mit nur einer Gleichspannungsquelle 9 auskommen, sofern auch die in der Zeichnung von den Gleichspannungsquellen 10 und 11 ausgehenden Leitungen mit der Gleichspannungsquelle 9 verbunden sind. In der Korrekturvorrichtung 5 sind jeweils zwei Stecker 6, 7, 8 über ein Leitungspaar 12a, 12b; 13a, 13b; 14a, 14b mit einer Gleichspannungsquelle 9, 10, 11 verbunden. Im vorliegenden Beispiel verbindet das Leitungspaar 12a, 12b die Stecker 8 und 6 mit der Gleichspannungsquelle 9. Das Leitungspaar 13a, 13b verbindet die Stecker 6 und 7 mit der Gleichspannungsquelle 10. Das Leitungspaar 14a, 14b verbindet die Stecker 7 und 8 mit der Gleichspannungsquelle 11. In jeweils eine der Leitungen 12b, 13b, 14b eines Leitungspaares ist ein bekannter ohmscher Widerstand 15, 16, 17 eingefügt. Von der Leitung 12b, 13b, 14b zwischen diesem ohmschen Widerstand 15, 16, 17 und dem Stecker 6, 7, 8 bzw. dem Anschlußpunkt 2b, 3b, 4b ausgehend sind zwischen den Leitungen jedes Leitungspaares 12a, 12b; 13a, 13b; 14a, 14b Spannungsmesser 18, 19, 20 angeordnet. Bei bekannter durch die Gleichspannungsquelle 9, 10, 11 angelegter Gleichspannung und bei bekanntem ohmschen Widerstand der Widerstände 15, 16, 17 zeigt jeder Spannungsmesser 18, 19, 20 den Spannungsabfall über die ohmschen Widerstände 2a, 3a, 4a von zwei der Anschlußleitungen 2, 3, 4 und über die ohmschen Widerstände 1a, 1b, 1c der mit diesen Anschlußleitungen 2, 3, 4 verbundenen Ständerwicklungen an.

Die Spannungsmesser 18, 19, 20 sind mit einer Auswerteeinheit 21 verbunden. Sie können auch in der Auswerteeinheit 21 integriert sein, so daß die Auswerteeinheit 21 direkt mit Abgriffen an den Leitungspaaren 12a, 12b; 13a, 13b; 14a, 14b verbunden sein kann. Dort werden die zur Korrektur der gemessenen Wirkleistung zu berücksichtigenden Leistungsverluste bestimmt. Da nur ohmsche Leistungsverluste mit dem Verfahren nach der Erfindung berücksichtigt werden, können die Messungen alle bei angelegter Gleichspannung erfolgen. Dadurch, daß die Leistungsverluste für die Anschlußleitungen 2, 3, 4 und die dazugehörigen Ständerwicklungen des Antriebs 1 paarweise bestimmt werden, erzielt man eine hohe Genauigkeit. Zum Bestimmen der Leistungsverluste werden in der Auswerteeinheit 21 aus den Meßwerten der Spannungsmesser 18, 19, 20 durch Vergleichen dieser Meßwerte die Spannungsabfälle über die Widerstandspaare 1a, 2a; 1b, 3a; 1c, 4a bestimmt. Durch Multiplizieren mit der zu ermittelnden Stromstärke erhält man die Leistungsverluste. Diese Leistungsverluste sind von der Wirkleistung zu subtrahieren, die während der Antrieb 1 in Betrieb ist, bestimmt wird. Die dadurch ermittelte korrigierte Wirkleistung des Antriebs 1 entspricht weitgehend der tatsächlichen Leistung des Antriebs 1 und kann mit geringem Fehler mit der mechanischen Leistung des Antriebs 1 und damit mit der mechanischen Leistung der mit dem Antrieb 1 verbundenen Armatur gleichgesetzt werden. Die korrigierte Wirkleistung ist ein zuverlässiges Maß für den Zustand des Antriebs 1 und der Armatur. Es müssen keine nur aufwendig zu bestimmende mechanischen Meßgrößen herangezogen werden, um bei einer Armaturendiagnose den Zustand und die Zuverlässigkeit der Armatur erkennen zu können.

Durch die Berücksichtigung der Leistungsverluste in den Anschlußleitungen 2, 3, 4 erhält man auch dann zuverlässige Aussagen über den Zustand des Antriebes 1 und der Armatur, wenn die Anschlußleitungen 2, 3, 4 sehr lang sind. Man kann also Meßgeräte zur Armaturendiagnose, z.B. die Korrekturvorrichtung 5, in einer Kraftwerkswarte unterbringen, die 100 m oder mehr vom zu prüfenden Antrieb 1 entfernt sein kann, ohne daß Meßfehler entstehen. Damit wird die Armaturendiagnose vereinfacht, weil Messungen in der Nähe des Antriebs 1 und der Armatur aufwendig sind. Insbesondere bei Kernkraftwerken ist eine Messung in der Nähe der Armatur wegen der radioaktiven Strahlung aufwendig.

## Patentansprüche

1. Verfahren zum Bestimmen der Wirkleistung eines elektrischen Antriebs (1), insbesondere eines elektrischen Armaturenantriebs, wobei von der gemessenen Wirkleistung der ohmsche Leistungsverlust, der im Ständer des Antriebs (1) gegeben ist, subtrahiert wird,
**dadurch gekennzeichnet,** daß auch der ohmsche Leistungsverlust, der in der Anschlußleitung (2, 3, 4) des Antriebs (1) gegeben ist, subtrahiert wird.

2. Verfahren nach Anspruch 1,
**dadurch gekennzeichnet,** daß Leistungsverluste, die im Rotor des Antriebs (1) gegeben sind, nicht berücksichtigt werden.

3. Verfahren nach einem der Ansprüche 1 oder 2,
**dadurch gekennzeichnet,** daß induktive Leistungsverluste nicht berücksichtigt werden.

4. Einrichtung zum Bestimmen der Wirkleistung eines elektrischen Antriebs (1), insbesondere eines elektrischen Armaturenantriebs, der Anschlußleitungen (2, 3, 4) für Ständerwicklungen des Antriebs (1) umfaßt,
**dadurch gekennzeichnet,** daß jeweils zwei der Anschlußleitungen (2, 3, 4) an antriebsfernen Anschlußpunkten (2b, 3b, 4b) durch Leitungspaare (12a, 12b; 13a, 13b; 14a, 14b) mit einer Gleichspannungsquelle (9, 10, 11) verbunden sind, daß jeweils in eine der Leitungen (12b, 13b, 14b) der Leitungspaare (12a, 12b; 13a, 13b; 14a, 14b) ein bekannter ohmscher Widerstand (15, 16, 17) eingefügt ist, daß diese Leitung (12b, 13b, 14b) zwischen dem ohmschen Widerstand (15, 16, 17) und dem Anschlußpunkt (2b, 3b, 4b) über einen Spannungsmesser (18, 19, 20) mit der anderen Leitung (12a, 13a, 14a) des jeweiligen Leitungspaares (12a, 12b; 13a, 13b; 14a, 14b) verbunden ist und daß die Spannungsmesser (18, 19, 20) mit einer Auswerteeinheit (21) verbunden sind.

5. Einrichtung nach Anspruch 4,
**dadurch gekennzeichnet,** daß die Spannungsmesser (18, 19, 20) Bestandteil der Auswerteeinheit (21) sind, die zur Spannungsmessung mit Spannungsabgriffen an den Leitungspaaren (12a, 12b; 13a, 13b; 14a, 14b) verbunden ist.

## Claims

1. Method for determining the active power of an electric drive (1), in particular of an electric armature drive, wherein the ohmic power loss which occurs in the stator of the drive (1) is subtracted from the active power which is measured, characterised in that the ohmic power loss which occurs in the connecting line (2, 3, 4) of the drive (1) is also subtracted.

2. Method according to claim 1, characterised in that power losses which occur in the rotor of the drive (1) are not taken into account.

3. Method according to one of claims 1 or 2, characterised in that inductive power losses are not taken into account.

4. Device for determining the active power of an electric drive (1), in particular of an electric armature drive, which device contains connecting lines (2, 3, 4) for stator windings of the drive (1), characterised in that in each case two of the connecting lines (2, 3, 4) are connected at drive-remote connecting points (2b, 3b, 4b), by pairs of lines (12a, 12b; 13a, 13b; 14a, 14b), to a direct-voltage source (9, 10, 11), in that in each case a known ohmic resistor (15, 16, 17) is inserted into one of the lines (12b, 13b, 14b) of the pairs of lines (12a, 12b; 13a, 13b; 14a, 14b), in that between the ohmic resistor (15, 16, 17) and the connecting point (2b, 3b, 4b), this line (12b, 13b, 14b) is connected to the other line (12a, 13a, 14a) of the respective pair of lines (12a, 12b; 13a, 13b, 14a, 14b) by way of a voltmeter (18, 19, 20), and in that the voltmeters (18, 19, 20) are connected to an evaluating unit (21).

5. Device according to claim 4, characterised in that the voltmeters (18, 19, 20) are components of the evaluating unit (21), which in order to measure the voltage is connected to voltage taps at the pairs of lines (12a, 12b; 13a, 13b; 14a, 14b).

## Revendications

1. Procédé pour la détermination de la puissance utile d'un entraînement électrique (1), en particulier d'un entraînement électrique d'un appareillage, la perte de puissance ohmique existant dans le stator de l'entraînement (1) étant soustraite de la puissance utile mesurée, caractérisé en ce que la perte de puissance ohmique existant dans la ligne de raccordement (2, 3, 4) de l'entraînement (1) est elle aussi soustraite.

2. Procédé selon la revendication 1, caractérisé en ce que des pertes de puissance existant dans le rotor de l'entraînement (1) ne sont pas prises en compte.

3. Procédé selon l'une des revendications 1 ou 2, caractérisé en ce que des pertes de puissance inductives ne sont pas prises en compte.

4. Installation pour la détermination de la puissance utile d'un entraînement électrique (1), en particulier d'un entraînement électrique d'un appareillage, lequel comprend des lignes de raccordement (2, 3, 4) pour des enroulements statoriques de l'entraînement (1), caractérisée en ce qu'à chaque fois deux des lignes de raccordement (2, 3, 4) sont reliées au niveau de points de raccordement (2b, 3b, 4b) éloignés de l'entraînement, par des lignes jumelées (12a, 12b ; 13a, 13b ; 14a, 14b), à une source de tension continue (9, 10, 11), en ce qu'une résistance ohmique (15, 16, 17) connue est introduite à chaque fois dans l'une des lignes (12b, 13b, 14b) des lignes jumelées (12a, 12b ; 13a, 13b ; 14a, 14b), en ce que cette ligne (12b, 13b, 14b) est reliée entre la résistance ohmique (15, 16, 17) et le point de raccordement (2b, 3b, 4b) par l'intermédiaire d'un voltmètre (18, 19, 20) à l'autre ligne (12a, 13a, 14a) de la ligne jumelée (12a, 12b ; 13a, 13b ; 14a, 14b) respective et en ce que les voltmètres (18, 19, 20) sont reliés à une unité d'analyse (21).

5. Installation selon la revendication 4, caractérisée en ce que les voltmètres (18, 19, 20) font partie de l'unité d'analyse (21), laquelle est reliée à des prises de tension placées sur les lignes jumelées (12a, 12b ; 13a, 13b ; 14a, 14 b), pour mesurer la tension.
